# EUROPEAN PATENT SPECIFICATION

(11) **EP 3 161 876 B1**
(45) Date of publication and mention of the grant of the patent: **20.05.2020**
(21) Application number: 15733061.4
(22) Date of filing: 22.06.2015
(51) Int. Cl.: H01L 31/048, H01L 31/049

(54) **PHOTOVOLTAIC MODULES COMPRISING ORGANOCLAY**
FOTOVOLTAIKMODULE MIT ORGANOTON
MODULES PHOTOVOLTAÏQUES COMPRENANT UNE ARGILE ORGANIQUE

(30) Priority: 24.06.2014 US 201462016240 P
(43) Date of publication of application: 03.05.2017
(73) Proprietor: Dow Global Technologies LLC, Midland, MI 48674 (US)
(72) Inventor: BONEKAMP, Jeffrey E., Midland, MI 48640-4412 (US); NANJUNDIAH, Kumar, Pearland, TX 77584 (US); ZHANG, Huiqing, Midland, MI 48642 (US); HU, Yushan, Pearland, TX 77584 (US)
(74) Representative: Boult Wade Tennant LLP
(86) International application number: PCT/US2015/036953
(87) International publication number: WO 2015/200204

(56) References cited:
- EP-A1- 2 726 283
- WO-A1-2013/129324
- CN-A- 103 724 778
- JP-A- 2005 113 076
- KR-A- 20120 119 815
- US-A1- 2014 096 825

## Description

### FIELD OF THE INVENTION

This invention relates photovoltaic (PV) modules and/or cells. In one aspect, the invention relates to the polyolefin films used in the construction of a PV module while in another aspect, the invention relates to increasing the volume resistivity of the polyolefin film used as a backsheet or encapsulant of a PV module.

### BACKGROUND OF THE INVENTION

KR 2012 0119815 discloses a solar cell encapsulant containing ethylene vinyl acetate (EVA) copolymer resin.
WO 2013/129324 relates to a protective shell for a solar cell.
CN 103 724 778 discloses a back encapsulant layer containing a polymeric composition prepared by a specific melt-mixing method, and a front encapsulant layer that may contain a polyolefin block copolymer.
JP 2005 113076 relates to a PV cell encapsulating layer containing EVA and a backing layer containing polyvinyl fluoride.
US 2014/096825 discloses a PV module structure having a single back film layer which is an integrated back encapsulating film/backsheet.
EP 2 726 283 relates to films having a layer comprising a Crystalline Block Composite ("CBC") or a specified Block Composite ("BC")and having improved combinations of properties; being particularly suited for use as protective layers, for example "backsheets", in electronic device (ED) modules, e.g., photovoltaic (PV) modules.

Films used in PV modules need to have good electrical volume resistivity for module performance. Module efficiency is related to electrical resistivity of the insulating layers. Low resistivity leads to higher leakage current of the insulating film which in turn leads to power loss to the frames. Accordingly, of continuing interest to the manufacturers of PV modules are insulating films with improved volume resistivity.

### SUMMARY OF THE INVENTION

In the first aspect of the invention there is provided the PV module of claim 1.

### BRIEF DESCRIPTION OF THE DRAWINGS

Figure 1 is a schematic of a PV module.
Figure 2 is a line graph reporting the leakage current of various encapsulant films.
Figure 3 is a side view schematic drawing of the single cell test module constructed and used in the examples.
Figure 4 is a top view schematic drawing of the single cell test module constructed and used in the examples.
Figure 5 is a line graph reporting the normalized power versus the time of ageing of single cell test modules at an elevated temperature.

### DETAILED DESCRIPTION OF THE INVENTION

### Definitions

Unless stated to the contrary, implicit from the context, or customary in the art, all parts and percents are based on weight and all test methods are current as of the filing date of this disclosure.

The numerical ranges in this disclosure are approximate, and thus may include values outside of the range unless otherwise indicated. Numerical ranges include all values from and including the lower and the upper values, in increments of one unit, provided that there is a separation of at least two units between any lower value and any higher value. As an example, if a compositional, physical or other property, such as, for example, molecular weight, viscosity, melt index, etc., is from 100 to 1,000, it is intended that all individual values, such as 100, 101, 102, etc., and sub ranges, such as 100 to 144, 155 to 170, 197 to 200, etc., are expressly enumerated. For ranges containing values which are less than one or containing fractional numbers greater than one (e.g., 1.1, 1.5, etc.), one unit is considered to be 0.0001, 0.001, 0.01 or 0.1, as appropriate. For ranges containing single digit numbers less than ten (e.g., 1 to 5), one unit is typically considered to be 0.1. These are only examples of what is specifically intended, and all possible combinations of numerical values between the lowest value and the highest value enumerated, are to be considered to be expressly stated in this disclosure. Numerical ranges are provided within this disclosure for, among other things, the amount of organoclay in the PV backsheet and/or encapsulant.

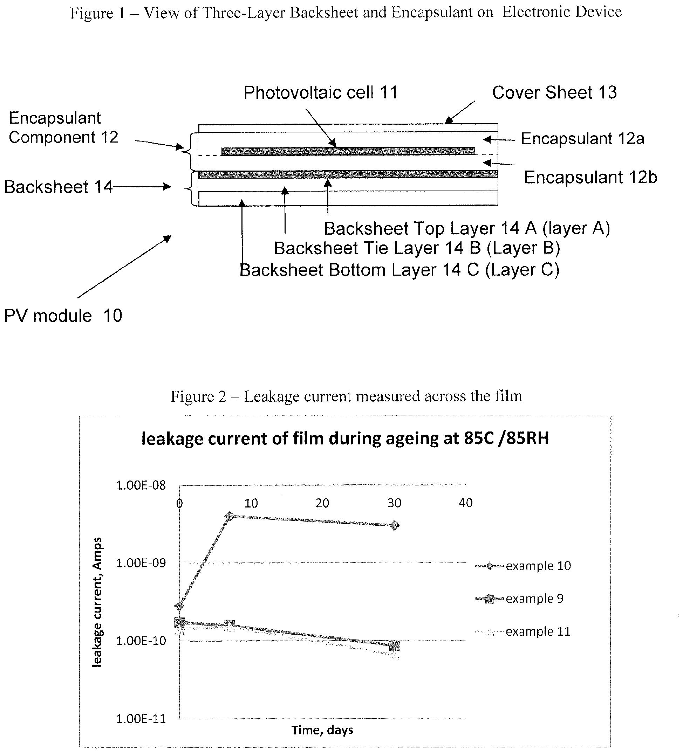

"Photovoltaic cells", "PV cells" and like terms mean a structure that contains one or more photovoltaic effect materials of any of several inorganic or organic types which are known in the art and from prior art photovoltaic module teachings. For example, commonly used photovoltaic effect materials include one or more of the known photovoltaic effect materials including crystalline silicon, polycrystalline silicon, amorphous silicon, copper indium gallium (di)selenide (CIGS), copper indium selenide (CIS), cadmium telluride, gallium arsenide, dye-sensitized materials, and organic solar cell materials. As shown in Figure 1, PV cells are typically employed in a laminate structure and have at least one light-reactive surface that converts the incident light into electric current. Photovoltaic cells are well known to practitioners in this field and are generally packaged into photovoltaic modules that protect the cell(s) and permit their usage in their various application environments, typically in outdoor applications. PV cells may be flexible or rigid in nature and include the photovoltaic effect materials and any protective coating surface materials that are applied in their production as well as appropriate wiring and electronic driving circuitry.

"Photovoltaic modules", "PV modules" and like terms mean a structure including a PV cell. In one embodiment the PV module is represented by the example structure shown in Figure 1, and it contains at least one photovoltaic cell 11 (in this case having a single light-reactive or effective surface directed or facing upward in the direction of the top of the page) surrounded or encapsulated by a light transmitting protective encapsulating sub-component 12a on the top or front surface and protective encapsulating sub-component 12b on the rear or back surface, which is optionally light transmitting. Combined, 12a and 12b form an encapsulating component 12, shown here as a combination of two encapsulating layers "sandwiching" the cell. The light transmitting cover sheet 13 has an interior surface in adhering contact with a front facial surface of encapsulating film layer 12a, which layer 12a is, in turn, disposed over and in adhering contact with PV cell 11. Backsheet film 14 (which can be single layered or, as shown here, multi-layered acts as a substrate and supports a rear surface of the PV cell 11 and optional encapsulating film layer 12b, which, in this case is disposed on a rear surface of PV cell 11. Back sheet layer 14 (and even encapsulating sub-layer 12b) need not be light transmitting if the surface of the PV cell to which it is opposed is not effective, i.e., reactive to sunlight. In the case of a flexible PV module, as the description "flexible" implies, it would comprise a flexible thin film photovoltaic cell 11.

"Composition" and like terms mean a mixture of two or more materials, such as a polymer which is blended with other polymers or which contains additives or fillers. Included in compositions are pre-reaction, reaction and post-reaction mixtures the latter of which will include reaction products and by-products as well as unreacted components of the reaction mixture and decomposition products, if any, formed from the one or more components of the pre-reaction or reaction mixture.

"Blend", "polymer blend" and like terms mean a composition of two or more polymers. Such a blend may or may not be miscible. Such a blend may or may not be phase separated. Such a blend may or may not contain one or more domain configurations, as determined from transmission electron spectroscopy, light scattering, x-ray scattering, and any other method known in the art. Blends are not laminates, but one or more layers of a laminate may contain a blend.

"Polymer" means a compound prepared by polymerizing monomers, whether of the same or a different type. The generic term polymer thus embraces the term homopolymer, usually employed to refer to polymers prepared from only one type of monomer, and the term interpolymer as defined below. It also embraces all forms of interpolymers, e.g., random, block, etc. The terms "ethylene/α-olefin polymer" and "propylene/α-olefin polymer" are indicative of interpolymers as described below. It is noted that although a polymer is often referred to as being "made of' monomers, "based on" a specified monomer or monomer type, or "containing" a specified monomer content, this is obviously understood to be referring to the polymerized remnant of the specified monomer and not to the unpolymerized species.

"Interpolymer" means a polymer prepared by the polymerization of at least two different monomers. This generic term includes copolymers, usually employed to refer to polymers prepared from two or more different monomers, and includes polymers prepared from more than two different monomers, e.g., terpolymers, tetrapolymers, etc.

"Polyolefin", "polyolefin polymer", "polyolefin resin" and like terms mean a polymer produced from a simple olefin (also called an alkene with the general formula CₙH₂ₙ) as a monomer. Polyethylene is produced by polymerizing ethylene with or without one or more comonomers, polypropylene by polymerizing propylene with or without one or more comonomers, etc. Thus, polyolefins include interpolymers such as ethylene/α-olefin copolymers, propylene/α-olefin copolymers, etc.

"(Meth)" indicates that the methyl substituted compound is included in the term. For example, the term "ethylene-glycidyl (meth)acrylate" includes ethylene-glycidyl acrylate (E-GA) and ethylene-glycidyl methacrylate (E-GMA), individually and collectively.

"Melting Point" as used here is typically measured by the differential scanning calorimetry (DSC) technique for measuring the melting peaks of polyolefins as described in USP 5,783,638. Many blends comprising two or more polyolefins will have more than one melting peak; many individual polyolefins will comprise only one melting peak.

### PV Module

The invention is described in the context of a PV module as illustrated in Figure 1 with the understanding that the PV module construction and materials of construction can vary widely, e.g., the backsheet is multilayered, the polymers of the encapsulant and backsheet constructions can vary, the materials and construction of the PV cell can vary, etc. Central to the invention is the ability of the organoclay to capture charges, electron and / or ions in the polymers that, if left uncaptured, can lead to leakage current and a resulting loss of PV cell efficiency.

### Layer C of the Backsheet

In one embodiment, the polyolefin resins useful in the bottom layer or Layer C of the backsheet have a melting point of at least 125°C, preferably greater than 140°C, more preferably greater than 150°C and even more preferably greater than 160°C. These polyolefin resins are preferably propylene-based polymers, commonly referred to as polypropylenes. These polyolefins are preferably made with multi-site catalysts, e.g., Zeigler-Natta and Phillips catalysts. In general, polyolefin resins with a melting point of at least 125°C often exhibit desirable toughness properties useful in the protection of the electronic device of the module.

Regarding polyolefin resins in general, such as suitable for Layer C or for other polymer components of the present invention, the sole monomer (or the primary monomer in the case of interpolymers) is typically selected from ethylene, propene (propylene), 1-butene, 4-methyl-1-pentene, 1-hexene, 1-octene, 1-decene, 1-dodecene, 1-tetradecene, 1-hexadecene, and 1-octadecene and is preferably propylene for the Layer C polyolefin resin. If the polyolefin resin is an interpolymer, then the comonomer(s) different from the first or primary monomer is/are typically one or more α-olefins. For purposes of this invention, ethylene is an α-olefin if propylene or higher olefin is the primary monomer. The co-α-olefin is then preferably a different C₂₋₂₀ linear, branched or cyclic α-olefin. Examples of C₂₋₂₀ α-olefins for use as comonomers include ethylene, propene (propylene), 1-butene, 4-methyl-1-pentene, 1-hexene, 1-octene, 1-decene, 1-dodecene, 1-tetradecene, 1-hexadecene, and 1-octadecene. The α-olefins for use as comonomers can also contain a cyclic structure such as cyclohexane or cyclopentane, resulting in an α-olefin such as 3-cyclohexyl-1-propene (allyl cyclohexane) and vinyl cyclohexane. Although not α-olefins in the classical sense of the term, for purposes of this invention certain cyclic olefins, such as norbornene and related olefins, are α-olefins and can be used as comonomer in place of some or all of the α-olefins described above. Similarly, styrene and its related olefins (for example, α-methylstyrene, etc.) are α-olefins for purposes of comonomers according to this invention. Acrylic and methacrylic acid and their respective ionomers, and acrylates and methacrylates are also comonomer α-olefins for purposes of this invention. Illustrative polyolefin copolymers include ethylene/propylene, ethylene/butene, ethylene/1-hexene, ethylene/1-octene, ethylene/styrene, ethylene/acrylic acid (EAA), ethylene/methacrylic acid (EMA), ethylene/acrylate or methacrylate and EVA. Illustrative terpolymers include ethylene/propylene/1-octene, ethylene/propylene/butene, ethylene/butene/1-octene, and ethylene/butene/styrene. The copolymers can be random or blocky.

High melting point polyolefin resins (having a melting point of at least 125°C), that are useful in the present invention and preferred for use as all or most of bottom Layer C of the multilayer backsheet of Figure 1 include propylene-based polymers, also referred to as propylene polymers or polypropylenes, including e.g., polypropylene or propylene copolymers comprising a majority of units derived from propylene and a minority of units derived from another α-olefin (including ethylene). These propylene-based polymers include polypropylene homopolymer, copolymers of propylene and one or more other olefin monomers, a blend of two or more homopolymers or two or more copolymers, and a blend of one or more homopolymer with one or more copolymer, as long as it has a melting point of 125°C or more. The polypropylene-based polymers can vary widely in form and include, for example, substantially isotactic propylene homopolymer, random propylene copolymers, and graft or block propylene copolymers.

The propylene copolymers preferably comprise at least 85, more preferably at least 87 and even more preferably at least 90, mole percent units derived from propylene. The remainder of the units in the propylene copolymer is derived from units of at least one α-olefin having up to about 20, preferably up to 12 and more preferably up to 8, carbon atoms. The α-olefin is preferably a C₃₋₂₀ linear, branched or cyclic α-olefin as described above.

In general, preferred propylene polymer resins include homopolymer polypropylenes, preferably high crystallinity polypropylene such as high stiffness and toughness polypropylenes. Preferably the propylene polymer MFR (measured in dg/min at 230°C/2.16kg) is at least about 0.5, preferably at least about 1.5, and more preferably at least about 2.5 dg/min and less than or equal to about 25, preferably less than or equal to about 20, and most preferably less than or equal to about 18 dg/min.

In general, preferred propylene polymer resins for Layer C have heat of fusion values (reflecting the relatively higher crystallinity) as measured by DSC of at least about 60 Joules per gram (J/g), more preferably at least about 90 J/g, still more preferably at least about 110 J/g and most preferably at least about 120J/g. For the heat of fusion measurements, as generally known and performed by practitioners in this area, the DSC is run as generally described below under nitrogen at 10°C/min from 23°C to 220°C, held isothermal at 220°C for 3 minutes, dropped to 23°C at 10°C/min and ramped back to 220°C at 10°C/min. The second heat data is used to calculate the heat of fusion of the melting transition.

The following are illustrative propylene polymers that can be used in the backsheets of this invention: a propylene impact copolymer including Brakem Polypropylene T702-12N; a propylene homopolymer including Braskem Polypropylene H502-25RZ; and a propylene random copolymer including Braskem Polypropylene R751-12N. Other polypropylenes include some of the VERSIFY® polymers available from The Dow Chemical Company, the VISTAMAXX® polymers available from ExxonMobil Chemical Company, and the PRO-FAX polymers available from Lyondell Basell Industries, e.g., PROFAX^{tm} SR-256M, which is a clarified propylene copolymer resin with a density of 0.90 g/cc and a MFR of 2 g/10 min, PROFAX^{tm} 8623, which is an impact propylene copolymer resin with a density of 0.90 g/cc and a MFR of 1.5 g/10 min. Still other propylene resins include CATALLOY^{tm} in-reactor blends of polypropylene (homo- or copolymer) with one or more of propylene-ethylene or ethylene-propylene copolymer (all available from Basell, Elkton, MD), Shell's KF 6100 propylene homopolymer; Solvay's KS 4005 propylene copolymer; and Solvay's KS 300 propylene terpolymer. Furthermore, INSPIRE^{tm} D114, which is a branched impact copolymer polypropylene with a melt flow rate (MFR) of 0.5 dg/min (230°C/2.16kg) and a melting point of 164°C would be a suitable polypropylene. In general, suitable high crystallinity polypropylene with high stiffness and toughness include INSPIRE™ 404 with an MFR of 3 dg/min, and INSPIRE^{tm} D118.01 with a melt flow rate of 8.0 dg/min (230°C/2.16kg), (both also available from Braskem).

Propylene polymer blend resins can also be used where polypropylene resins as described above can be blended or diluted with one or more other polymers, including polyolefins as described below, to the extent that the other polymer is (i) miscible or compatible with the polypropylene, (ii) has little, if any, deleterious impact on the desirable properties of the polypropylene, e.g., toughness and modulus, and (iii) the polypropylene constitutes at least about 55, preferably at least about 60, more preferably at least about 65 and still more preferably at least about 70, weight percent of the blend. The propylene polymer can be also be blended with cyclic olefin copolymers such as Topas 6013F-04 cyclic olefin copolymer available from Topas Advanced Polymers, Inc. with preferred amounts when used at least about 2, preferably 4, and more preferably 8 weight percent up to and including to 40, preferably 35 and more preferably 30 weight percent. In general, propylene polymer resins for Layer C can comprise an impact modifier such as ethylene octene plastomers such as AFFINITY PL 1880G, PL8100G, and PL 1850G available from The Dow Chemical Company. In general, these are used in amounts at least of about 2 weight percent, preferably at least about 5 and more preferably at least about 8 weight percent and preferably less than about 45 weight %, preferably less than about 35 weight percent and more preferably less than about 30 weight percent. Other candidate impact modification or blend resins are ethylene/propylene rubbers (optionally blended with polypropylene in-reactor) and one or more block composites as described herein. Combinations of impact modifiers of different types may also be used.

Other additives that could be used with the propylene polymer resins are inorganic fillers such as talc (including epoxy coated talc), colorants, flame retardants (halogenated and non-halogenated) and flame retardant synergists such as Sb₂O₃.

### Layer B of the Backsheet

The composition of Layer B of the backsheet of one embodiment of the invention, often referred to as a "tie" layer, is selected to be adhered, either preferably by co-extrusion or alternatively but less preferably by a lamination process (such as *extrusion lamination, thermal lamination, or adhesive lamination)* to the layers C and A (or optionally another layer). Layer B comprises a Crystalline Block Copolymer Composite Resin ("CBC") and optionally certain Block copolymer Composite Resins ("BC's"), CBC's and BC's collectively referred to herein as "Crystalline Block and Block Composite Resins" "Composite Resins" or "(C)BC's". Layer B can alternatively comprise a blend of one or more CBC and with one or more BC, or a blend of one or both of these resins with one or more other resin.

The term "block copolymer" or "segmented copolymer" refers to a polymer comprising two or more chemically distinct regions or segments (referred to as "blocks") joined in a linear manner, that is, a polymer comprising chemically differentiated units which are joined (covalently bonded) end-to-end with respect to polymerized functionality, rather than in pendent or grafted fashion. In a preferred embodiment, the blocks differ in the amount or type of comonomer incorporated therein, the density, the amount of crystallinity, the type of crystallinity (e.g. polyethylene versus polypropylene), the crystallite size attributable to a polymer of such composition, the type or degree of tacticity (isotactic or syndiotactic), regio-regularity or regio-irregularity, the amount of branching, including long chain branching or hyper-branching, the homogeneity, or any other chemical or physical property. The block copolymers of the invention are characterized by unique distributions of both polymer polydispersity (PDI or Mw/Mn) and block length distribution, due, in a preferred embodiment, to the effect of a shuttling agent(s) in combination with the catalyst(s).

As used herein, the terms "block composite" or "block copolymer composite" resins are different from "crystalline block composites" or "crystalline block copolymer composite resins" based on the amount of comonomer polymerized with the ethylene polymer and ethylene block in the composite. The term "BC" refers generally to polymers comprising (i) a soft ethylene copolymer (EP) having polymerized units in which the comonomer content is greater than 10 mol% and less than 90 mol% polymerized ethylene, and preferably greater than 20 mol% and less than 80 mol%, and most preferably greater than 33 mol% and less than 75 mol%, (ii) a hard or crystalline α-olefin polymer (CAOP), in which the α-olefin monomer is present in an amount of from greater than 90 up to 100 mol percent, and preferably greater than 93 mol percent, and more preferably greater than 95 mol percent, and most preferably greater than 98 mol percent and (iii) a block copolymer, preferably a diblock, having a soft segment and a hard segment, wherein the hard segment of the block copolymer is essentially the same composition as the hard α-olefin polymer in the block composite and the soft segment of the block copolymer is essentially the same composition as the soft ethylene copolymer of the block composite. The block copolymers can be linear or branched. More specifically, when produced in a continuous process, the block composites desirably possess PDI from 1.7 to 15, preferably from 1.8 to 3.5, more preferably from 1.8 to 2.2, and most preferably from 1.8 to 2.1. When produced in a batch or semi-batch process, the block composites desirably possess PDI from 1.0 to 2.9, preferably from 1.3 to 2.5, more preferably from 1.4 to 2.0, and most preferably from 1.4 to 1.8. Such block composites are described in, for example, US Patent Application Publication Nos US2011-0082257, US2011-0082258 and US2011-0082249, all published on April 7, 2011.

As mentioned above, alternatively or in addition to the CBC (discussed in more detail below), certain suitable "BC" resins can be employed in Layer B in the films according to the present invention. The specific suitable "BC's" comprise a soft ethylene copolymer (EP) having the comonomer content greater than 80 mol% and up to 90 mol% and preferably greater than 85 mol% and most preferably greater than 87 mol%, but otherwise a BC as generally described herein.

The term "crystalline block composite" (CBC) (including the term "crystalline block copolymer composite") refers to polymers comprising a crystalline ethylene based polymer (CEP), a crystalline alpha-olefin based polymer (CAOP), and a block copolymer having a crystalline ethylene block (CEB) and a crystalline alpha-olefin block (CAOB), wherein the CEB of the block copolymer is the same composition as the CEP in the block composite and the CAOB of the block copolymer is the same composition as the CAOP of the block composite. Additionally, the compositional split between the amount of CEP and CAOP will be essentially the same as that between the corresponding blocks in the block copolymer. The block copolymers can be linear or branched. More specifically, each of the respective block segments can contain long chain branches, but the block copolymer segment is substantially linear as opposed to containing grafted or branched blocks. When produced in a continuous process, the crystalline block composites desirably possess PDI from 1.7 to 15, preferably 1.8 to 10, preferably from 1.8 to 5, more preferably from 1.8 to 3.5. Such crystalline block composites are described in, for example, the following filed patent applications: PCT/US11/41189; US 13/165054; PCT/US11/41191; US 13/165073; PCT/US11/41194; and US 13/165096; all filed on 21 June 2011.

CAOB refers to highly crystalline blocks of polymerized alpha olefin units in which the monomer is present in an amount greater than 90 mol%, preferably greater than 93 mol percent, more preferably greater than 95 mol percent, and preferably greater than 96 mol percent. In other words, the comonomer content in the CAOBs is less than 10 mol percent, and preferably less than 7 mol percent, and more preferably less than 5 mol percent, and most preferably less than 4 mol%. CAOBs with propylene crystallinity have corresponding melting points that are 80°C and above, preferably 100°C and above, more preferably 115°C and above, and most preferably 120°C and above. In some embodiments, the CAOB comprise all or substantially all propylene units. CEB, on the other hand, refers to blocks of polymerized ethylene units in which the comonomer content is 10 mol% or less, preferably between 0 mol% and 10 mol%, more preferably between 0 mol% and 7 mol% and most preferably between 0 mol% and 5 mol%. Such CEB have corresponding melting points that are preferably 75°C and above, more preferably 90°C, and 100°C and above.

"Hard" segments refer to highly crystalline blocks of polymerized units in which the monomer is present in an amount greater than 90 mol percent, and preferably greater than 93 mol percent, and more preferably greater than 95 mol percent, and most preferably greater than 98 mol percent. In other words, the comonomer content in the hard segments is most preferably less than 2 mol percent, and more preferably less than 5 mol percent, and preferably less than 7 mol percent, and less than 10 mol percent. In some embodiments, the hard segments comprise all or substantially all propylene units. "Soft" segments, on the other hand, refer to amorphous, substantially amorphous or elastomeric blocks of polymerized units in which the comonomer content is greater than 10 mol% and less than 90 mol% and preferably greater than 20 mol% and less than 80 mol%, and most preferably greater than 33 mol% and less than 75 mol%.

The BC's and/or CBC's are preferably prepared by a process comprising contacting an addition polymerizable monomer or mixture of monomers under addition polymerization conditions with a composition comprising at least one addition polymerization catalyst, a co-catalyst and a chain shuttling agent, said process being characterized by formation of at least some of the growing polymer chains under differentiated process conditions in two or more reactors operating under steady state polymerization conditions or in two or more zones of a reactor operating under plug flow polymerization conditions. In a preferred embodiment, the BC's and/or CBC's comprise a fraction of block polymer which possesses a most probable distribution of block lengths.

Suitable processes useful in producing the block composites and crystalline block composites may be found, for example, in US. 2008/0269412.

Suitable catalysts and catalyst precursors for use in preparing BC's and/or CBC's invention include metal complexes such as disclosed in WO2005/090426, in particular, those disclosed starting on page 20, line 30 through page 53, line 20. Suitable catalysts are also disclosed in US 2006/0199930; US 2007/0167578; US 2008/0311812; US 7,355,089 B2; or WO 2009/012215.

Preferably, the BC's and/or CBC's comprise propylene, 1-butene or 4-methyl-1-pentene and one or more comonomers. Preferably, the block polymers of the BC's and CBC's comprise in polymerized form propylene and ethylene and/or one or more C₄₋₂₀ α-olefin comonomers, and/or one or more additional copolymerizable comonomers or they comprise 4-methyl-1-pentene and ethylene and/or one or more C₄₋₂₀ α-olefin comonomers, or they comprise 1-butene and ethylene, propylene and/or one or more C₅-C₂₀ α-olefin comonomers and/or one or more additional copolymerizable comonomers. Additional suitable comonomers are selected from diolefins, cyclic olefins, and cyclic diolefins, halogenated vinyl compounds, and vinylidene aromatic compounds.

Comonomer content in the resulting BC's and/or CBC's may be measured using any suitable technique, with techniques based on nuclear magnetic resonance (NMR) spectroscopy preferred. It is highly desirable that some or all of the polymer blocks comprise amorphous or relatively amorphous polymers such as copolymers of propylene, 1-butene or 4-methyl-1-pentene and a comonomer, especially random copolymers of propylene, 1-butene or 4-methyl-1-pentene with ethylene, and any remaining polymer blocks (hard segments), if any, predominantly comprise propylene, 1-butene or 4-methyl-1-pentene in polymerized form. Preferably such segments are highly crystalline or stereospecific polypropylene, polybutene or poly-4-methyl-1-pentene, especially isotactic homopolymers.

Further preferably, the block copolymers of the BC's and/or CBC's comprise from 10 to 90 weight percent crystalline or relatively hard segments and 90 to 10 weight percent amorphous or relatively amorphous segments (soft segments), preferably from 20 to 80 weight percent crystalline or relatively hard segments and 80 to 20 weight percent amorphous or relatively amorphous segments (soft segments), most preferably from 30 to 70 weight percent crystalline or relatively hard segments and 70 to 30 weight percent amorphous or relatively amorphous segments (soft segments). Within the soft segments, the mole percent comonomer may range from 10 to 90 mole percent, preferably from 20 to 80 mole percent, and most preferably from 33 to 75 mol% percent. In the case wherein the comonomer is ethylene, it is preferably present in an amount of 10 mol% to 90 mol%, more preferably from 20 mol% to 80 mol%, and most preferably from 33 mol% to 75 mol% percent. Preferably, the copolymers comprise hard segments that are 90 mol% to 100 mol% propylene. The hard segments can be greater than 90 mol% preferably greater than 93 mol% and more preferably greater than 95 mol% propylene, and most preferably greater than 98 mol% propylene. Such hard segments have corresponding melting points that are 80°C and above, preferably 100°C and above, more preferably 115°C and above, and most preferably 120°C and above.

In some embodiments, the block copolymer composites of the invention have a Block Composite Index (BCI), as defined below, that is greater than zero but less than about 0.4 or from about 0.1 to about 0.3. In other embodiments, BCI is greater than about 0.4 and up to about 1.0. Additionally, the BCI can be in the range of from about 0.4 to about 0.7, from about 0.5 to about 0.7, or from about 0.6 to about 0.9. In some embodiments, BCI is in the range of from about 0.3 to about 0.9, from about 0.3 to about 0.8, or from about 0.3 to about 0.7, from about 0.3 to about 0.6, from about 0.3 to about 0.5, or from about 0.3 to about 0.4. In other embodiments, BCI is in the range of from about 0.4 to about 1.0, from about 0.5 to about 1.0, or from about 0.6 to about 1.0, from about 0.7 to about 1.0, from about 0.8 to about 1.0, or from about 0.9 to about 1.0.

The block composites preferably have a Tm greater than 100 °C, preferably greater than 120 °C, and more preferably greater than 125 °C. Preferably the MFR of the block composite is from 0.1 to 1000 dg/min, more preferably from 0.1 to 50 dg/min and more preferably from 0.1 to 30 dg/min.

Further preferably, the block composites of this embodiment of the invention have a weight average molecular weight (Mw) from 10,000 to about 2,500,000, preferably from 35000 to about 1,000,000 and more preferably from 50,000 to about 300,000, preferably from 50,000 to about 200,000.

Preferably, the block composite polymers of the invention comprise ethylene, propylene, 1-butene or 4-methyl-1-pentene and optionally one or more comonomers in polymerized form. Preferably, the block copolymers of the crystalline block composites comprise in polymerized form ethylene, propylene, 1-butene, or 4-methyl-1-pentene and optionally one or more C₄₋₂₀ α-olefin comonomers. Additional suitable comonomers are selected from diolefins, cyclic olefins, and cyclic diolefins, halogenated vinyl compounds, and vinylidene aromatic compounds.

Comonomer content in the resulting block composite polymers may be measured using any suitable technique, with techniques based on nuclear magnetic resonance (NMR) spectroscopy preferred.

Preferably the crystalline block composite polymers of the invention comprise from 0.5 to 95 wt % CEP, from 0.5 to 95 wt % CAOP and from 5 to 99 wt % block copolymer. More preferably, the crystalline block composite polymers comprise from 0.5 to 79 wt % CEP, from 0.5 to 79 wt % CAOP and from 20 to 99 wt % block copolymer and more preferably from 0.5 to 49 wt % CEP, from 0.5 to 49 wt % CAOP and from 50 to 99 wt % block copolymer. Weight percents are based on total weight of crystalline block composite. The sum of the weight percents of CEP, CAOP and block copolymer equals 100%.

Preferably, the block copolymers of the invention comprise from 5 to 95 weight percent crystalline ethylene blocks (CEB) and 95 to 5 wt percent crystalline alpha-olefin blocks (CAOB). They may comprise 10 wt% to 90 wt% CEB and 90 wt % to 10 wt% CAOB. More preferably, the block copolymers comprise 25 to 75 wt% CEB and 75 to 25 wt% CAOB, and even more preferably they comprise 30 to 70 wt % CEB and 70 to 30 wt % CAOB.

In some embodiments, the block composites of the invention have a Crystalline Block Composite Index (CBCI), as defined below, that is greater than zero but less than about 0.4 or from about 0.1 to about 0.3. In other embodiments, CBCI is greater than about 0.4 and up to about 1.0. In some embodiments, the CBCI is in the range of from about 0.1 to about 0.9, from about 0.1 to about 0.8, from about 0.1 to about 0.7 or from about 0.1 to about 0.6. Additionally, the CBCI can be in the range of from about 0.4 to about 0.7, from about 0.5 to about 0.7, or from about 0.6 to about 0.9. In some embodiments, CBCI is in the range of from about 0.3 to about 0.9, from about 0.3 to about 0.8, or from about 0.3 to about 0.7, from about 0.3 to about 0.6, from about 0.3 to about 0.5, or from about 0.3 to about 0.4. In other embodiments, CBCI is in the range of from about 0.4 to about 1.0, from about 0.5 to about 1.0, or from about 0.6 to about 1.0, from about 0.7 to about 1.0, from about 0.8 to about 1.0, or from about 0.9 to about 1.0.

Further preferably, the crystalline block composites of this embodiment of the invention have a weight average molecular weight (Mw) of 1,000 to about 2,500,000, preferably of 35000 to about 1,000,000 and more preferably of 50,000 to 500,000, of 50,000 to about 300,000, and preferably from 50,000 to about 200,000.

The overall composition of each resin is determined by Differential Scanning Calorimetry (DSC), NMR, Gel Permeation Chromatography (GPC), Dynamic Mechanical Spectroscopy (DMS), and Transmission Electron Microscope (TEM) morphology. Xylene fractionation and High temperature Liquid Chromatography (HTLC) fractionation can be further used to estimate the yield of block copolymer, and in particular the block composite index. These are described in more detail in US Patent Application Publication Nos US2011-0082257, US2011-0082258 and US2011-0082249.

Differential Scanning Calorimetry is used to measure, among other things, the heats of fusion of the crystalline block and block composites and is performed on a TA Instruments Q1000 DSC equipped with an RCS cooling accessory and an auto sampler. A nitrogen purge gas flow of 50 ml/min is used. The sample is pressed into a thin film and melted in the press at about 190°C and then air-cooled to room temperature (25°C). About 3-10 mg of material is then cut, accurately weighed, and placed in a light aluminum pan (ca 50 mg) which is later crimped shut. The thermal behavior of the sample is investigated with the following temperature profile: the sample is rapidly heated to 190°C and held isothermal for 3 minutes in order to remove any previous thermal history. The sample is then cooled to - 90°C at 10°C/min cooling rate and held at -90°C for 3 minutes. The sample is then heated to 190°C at 10°C/min heating rate. The cooling and second heating curves are recorded. For the heat of fusion measurements for the CBC and specified BC resins, as known and routinely performed by skilled practitioners in this area, the baseline for the calculation is drawn from the flat initial section prior to the onset of melting (typically in the range of from about -10 to about 20 °C for these types of materials) and extends to the end of melting for the second heating curve.

To summarize:
Suitable block composite resins (BC's) comprise:
i) An ethylene polymer (EP) comprising from about 80 to about 90 mol % polymerized ethylene, preferably at least about 85 mol %;
ii) An alpha-olefin-based crystalline polymer (CAOP); and
iii) a block copolymer comprising (a) an ethylene polymer block (EB) comprising from about 80 to about 90 mol % ethylene and (b) a crystalline alpha-olefin block (CAOB).

Crystalline block composite resins (CBC's) comprise:
i) a crystalline ethylene polymer (CEP) comprising at least greater than about 90 mol % polymerized ethylene, preferably at least about 93 mol %;
ii) an alpha-olefin-based crystalline polymer (CAOP); and
iii) a block copolymer comprising (a) a crystalline ethylene polymer block (CEB) comprising at least greater than about 90 mol % polymerized ethylene, preferably at least about 93 mol % and (b) a crystalline alpha-olefin block (CAOB).

Another way to collectively summarize the suitable resin(s) used in Layer B is as comprising a CBC or a specified BC comprising:
i) an ethylene polymer comprising at least about 80 mol % polymerized ethylene, preferably at least about 85 mol %, more preferably at least about 90 mol%, and most preferably at least about 93 mol % polymerized ethylene;
ii) an alpha-olefin-based crystalline polymer (CAOP); and
iii) a block copolymer comprising (a) an ethylene polymer block comprising at least about 80 mol % polymerized ethylene, preferably at least about 85 mol %, more preferably at least about 90 mol%, and most preferably at least about 93 mol % polymerized ethylene and (b) a crystalline alpha-olefin block (CAOB).

Preferred suitable BC and/or CBC resin(s) for Layer B have a CAOB amount (in part (iii)) in the range of from about 30 to about 70 weight % (based on (iii)), preferably at least about 40wt%, more preferabley at least about 45 wt % and most preferably about 50wt%, and preferably up to about 60 wt%, and preferably up to about 55 wt% (the balance in each case being ethylene polymer). It has also been found that the BC and/or CBC resin(s) suitable for Layer B have a (crystalline) block composite index of at least about 0.1, preferably at least about 0.3, preferably at least about 0.5 and more preferably at least about 0.7. Another way to characterize the suitable BC and/or CBC resin(s) essential for Layer B is as having a MFR in the range of from about 1 to about 50 dg/min; preferably at least about 2, more preferably at least about 3; and preferably up to about 40, and preferably up to about 30 g/min.

In general, BC's that can be used in Layer B according to the present invention will have heat of fusion values (generally related to their ethylene content in the EP and EB) of at least about 75 Joules per gram (J/g), more preferably at least about 80 J/g, still more preferably at least about 85 J/g and most preferably at least about 90 J/g, as measured by DSC. In general, CBC's that can be used in Layer B according to the present invention will have heat of fusion values (reflecting the relatively higher ethylene content in the CEP and CEB) as measured by DSC of at least about 85 Joules per gram (J/g), more preferably at least about 90 J/g. In either case, the heat of fusion values for polymers of these types would generally have a maximum in the area of about 125 J/g. For the heat of fusion measurements, as generally known and performed by practitioners in this area, the DSC is run as generally described below under nitrogen at 10°C/min from 23°C to 220°C, held isothermal at 220°C, dropped to 23°C at 10°C/min and ramped back to 220°C at 10°C/min. The second heat data is used to calculate the heat of fusion of the melting transition.

Blends of these resins can also be used where blended or diluted with one or more other polymers, including polyolefins as described herein, to the extent that (i) the other polymer is miscible or highly compatible with the BC and/or CBC , (ii) the other polymer has little, if any, deleterious impact on the desirable properties of the polyolefin block copolymer composite, e.g., toughness and modulus, and (iii) the BC and/or CBC resin(s) constitute from at least about 40 to 99 weight percent of the blend, preferably at least about 60, more preferably at least about 75, and more preferably at least about 80 weight percent of the blend. Blending can be used to provide: improve compatibility (adhesion) with C and/or other layers under a range of conditions and lower costs. In particular, blends would desirably be employed where Layer B is employed as surface layer, as discussed below, and this film surface needs properties sufficient for roll-up, handling, packaging, transport and assembly into final laminate structures, such as into electronic device modules.

### Layer A of the Backsheet

Layer A according to the present invention, often referred to as a "seal" layer, is selected to be adhered, either preferably by co-extrusion or alternatively but less preferably by a lamination process (such as extrusion lamination, thermal lamination, or adhesive lamination) to the tie layer (Layer B) in production of the film according to the invention and to adhere the film to other films or articles such as the encapsulation films employed in the assembly of electronic devices ("encapsulation films" being discussed in more detail below). Layer A materials can be selected from a very wide variety of different types of materials assembled in blends and/or layers as described in more detail below. Among other things, the relative thinness of Layer A distinguishes it from a layer that would serve as an "encapsulation" layer. The wide variety of candidate seal layer materials includes generally wide range of thermoplastic ethylene-based polymers, such as high pressure, free-radical low density polyethylene (LDPE), and ethylene-based polymers prepared with Ziegler-Natta catalysts, including high density polyethylene (HDPE) and heterogeneous linear low density polyethylene (LLDPE), ultra low density polyethylene (ULDPE), and very low density polyethylene (VLDPE), as well as multiple-reactor ethylenic polymers ("in reactor" blends of Ziegler-Natta PE and metallocene PE, such as products disclosed in U.S. Patent Nos. 6,545,088 (Kolthammer et al.); 6,538,070 (Cardwell et al.); 6,566,446 (Parikh et al.); 5,844,045 (Kolthammer et al.); 5,869,575 (Kolthammer et al.); and 6,448,341 (Kolthammer et al.)). Commercial examples of linear ethylene-based polymers include ATTANE™ Ultra Low Density Linear Polyethylene Copolymer, DOWLEX™ Polyethylene Resins, and FLEXOMER™ Very Low Density Polyethylene, all available from The Dow Chemical Company. Other suitable synthetic polymers include ethylene/diene interpolymers, ethylene acrylic acid (EAA), ethylene-vinyl acetate (EVA), ethylene ethyl acrylate (EEA), ethylene methyl acrylate (EMA), ethylene n-butyl acrylate (EnBA), ethylene methacrylic acid (EMAA), various types of ionomers, and ethylene/vinyl alcohol copolymers. Homogeneous olefin-based polymers such as ethylene-based plastomers or elastomers can also be useful as components in blends or compounds made with the ethylenic polymers of this invention. Commercial examples of homogeneous metallocene-catalyzed, ethylene-based plastomers or elastomers include AFFINITY™ polyolefin plastomers and ENGAGE™ polyolefin elastomers, both available from The Dow Chemical Company, and commercial examples of homogeneous propylene-based plastomers and elastomers include VERSIFY™ performance polymers, available from The Dow Chemical Company, and VISTAMAX ™ polymers available from ExxonMobil Chemical Company.

### Layer A Olefinic Interpolymers

Some specific preferred examples of olefinic interpolymers useful in this invention, particularly in the top layer of the backsheet, include very low density polyethylene (VLDPE) (e.g., FLEXOMER® ethylene/1-hexene polyethylene made by The Dow Chemical Company), homogeneously branched, linear ethylene/α-olefin copolymers (e.g. TAFMER® by Mitsui Petrochemicals Company Limited and EXACT® by Exxon Chemical Company), homogeneously branched, substantially linear ethylene/α-olefin polymers (e.g., AFFINITY® and ENGAGE® polyethylene available from The Dow Chemical Company), and ethylene multi-block copolymers (e.g., INFUSE® olefin block copolymers available from The Dow Chemical Company). The more preferred polyolefin copolymers for use in the top layer of the backsheet are the homogeneously branched linear and substantially linear ethylene copolymers, particularly the substantially linear ethylene copolymers which are more fully described in USP 5,272,236, 5,278,272 and 5,986,028, and the ethylene multi-block copolymers which are more fully described in USP 7,355,089, WO 2005/090427, US2006/0199931, US2006/0199930, US2006/0199914, US2006/0199912, US2006/0199911, US2006/0199910, US2006/0199908, US2006/0199906, US2006/0199905, US2006/0199897, US2006/0199896, US2006/0199887, US2006/0199884, US2006/0199872, US2006/0199744, US2006/0199030, US2006/0199006 and US2006/0199983.

### Layer A Polar Ethylene Copolymers

One preferred polar ethylene copolymer for use in the top layer of the claimed films is an EVA copolymer, including blends comprising EVA copolymers, that will form a sealing relationship with other films or layers, e.g., encapsulant, a glass cover sheet, etc. when brought into adhesive contact with the layer or other component. The ratio of units derived from ethylene to units derived from vinyl acetate in the copolymer, before grafting or other modification, can vary widely, but typically the EVA copolymer contains at least about 1, preferably at least about 2, more preferably at least about 4 and even more preferably at least about 6, wt% units derived from vinyl acetate. Typically, the EVA copolymer contains less than about 33 wt% units derived from vinyl acetate, preferably less than about 30, preferably less than about 25, preferably less than about 22, preferably less than about 18 and more preferably less than about 15 wt% units derived from vinyl acetate. The EVA copolymer can be made by any process including emulsion, solution and high-pressure polymerization.

The EVA copolymer before grafting or other modification typically has a density of less than about 0.95, preferably less than about 0.945, more preferably less than about 0.94, g/cc. The same EVA copolymer typically has a density greater than about 0.9, preferably greater than 0.92, and more preferably greater than about 0.925, g/cc. Density is measured by the procedure of ASTM D-792. EVA copolymers are generally characterized as semi-crystalline, flexible and having good optical properties, e.g., high transmission of visible and UV-light and low haze.

Another preferred polar ethylene copolymer useful as top layer of the backsheet is an ethylene acrylate copolymer such as ethylene ethyl acrylate (EEA) and ethylene methyl acrylate (EMA) copolymers, (including blends comprising either) that can also form a sealing relationship with the adjacent layer, such as an encapsulant layer in an electronic device module, when they are brought into adhesive contact. The ratio of units derived from ethylene to units derived from ethyl acrylate or methyl acrylate in the copolymer, before grafting or other modification, can vary widely, but typically the EEA or EMA copolymer contains at least about 1, preferably at least about 2, more preferably at least about 4 and even more preferably at least about 6, wt% units derived from the ethyl acrylate or methyl acrylate. Typically, the EEA or EMA copolymer contains less than about 28, preferably less than about 25, more preferably less than 22, and more preferably less than about 19, wt% units derived from ethyl acrylate or methyl acrylateacrylate.

These polar ethylene copolymers (e.g., EVA, EEA or EMA copolymers) typically have a melt index (MI as measured by the procedure of ASTM D-1238 (190C/2.16kg) of less than 100, preferably less than 75, more preferably less than 50 and even more preferably less than 30, g/10 min. The typical minimum MI is at least about 0.3, more preferably 0.7, and more preferably it is at least about 1 g/10 min.

One preferred top layer of the backsheet is a blend formulation of a linear low density polyethylene (LLDPE) comprising polar ethylene copolymer in an amount of from about 10 to about 45 weight % , the weight % depending upon the polar ethylene copolymer being used.

### Layer A MAH-m-Polyolefins

MAH-m-polyolefins are another preferred seal layer material and include MAH-g-polyolefins and MAH interpolymers, i.e., the MAH functionality is present in the polyolefin either by grafting onto the polymer backbone or incorporating the functionality into the backbone through copolymerization of MAH with the olefin monomer.

In one embodiment of the invention, the polyolefin is graft-modified to enhance the interlayer adhesion between the top layer and the bottom layer of the multilayer structure through a reaction of the grafted functionality with the reactive group present in the middle tie layer. Any material that can be grafted to the polyolefin and can react with the reactive group present in the tie layer can be used as the graft material.

Any unsaturated organic compound containing at least one ethylenic unsaturation (e.g., at least one double bond), at least one carbonyl group (-C=O), and that will graft to the polyolefin polymer and more particularly to EVA, EEA, EMA or polypropylene, can be used as the grafting material. Representative of compounds that contain at least one carbonyl group are the carboxylic acids, anhydrides, esters and their salts, both metallic and nonmetallic. Preferably, the organic compound contains ethylenic unsaturation conjugated with a carbonyl group. Representative compounds include maleic, fumaric, acrylic, methacrylic, itaconic, crotonic, α-methyl crotonic, and cinnamic acid and their anhydride, ester and salt derivatives, if any. Maleic anhydride is the preferred unsaturated organic compound containing at least one ethylenic unsaturation and at least one carbonyl group.

The unsaturated organic compound content of the graft polyolefin is at least about 0.01 wt %, and preferably at least about 0.05 wt %, based on the combined weight of the polyolefin and the organic compound. The maximum amount of unsaturated organic compound content can vary to convenience, but typically it does not exceed about 10 wt%, preferably it does not exceed about 5 wt%, and more preferably it does not exceed about 2 wt%. This unsaturated organic content of the graft polyolefin is measured by a titration method, e.g., a grafted polyolefin/xylene solution is titrated with a potassium hydroxide (KOH) solution. The MAH functionality can be present in the polyolefin e.g., by grafting, or even by copolymerization with the olefin monomer.

The unsaturated organic compound can be grafted to the polyolefin by any known technique, such as those taught in USP 3,236,917 and 5,194,509. For example, in the '917 patent the polymer is introduced into a two-roll mixer and mixed at a temperature of 60°C. The unsaturated organic compound is then added along with a free radical initiator, such as, for example, benzoyl peroxide, and the components are mixed at 30°C until the grafting is completed. In the '509 patent, the procedure is similar except that the reaction temperature is higher, e.g., 210 to 300°C, and a free radical initiator is not used or is used at a reduced concentration.

An alternative and preferred method of grafting is taught in USP 4,950,541 by using a twin-screw devolatilizing extruder as the mixing apparatus. The polymer and unsaturated organic compound are mixed and reacted within the extruder at temperatures at which the reactants are molten and in the presence of a free radical initiator. Preferably, the unsaturated organic compound is injected into a zone maintained under pressure within the extruder.

### Layer A Silane Grafted Ethylene-Based Polymers

In another preferred embodiment, a suitable material for Layer A can be provided by a silane grafted polyolefin as described below for use as the encapsulation layer, particularly as provided by silane grafting in the thermoplastic ethylene-based polymers described above, including in an olefinic interpolymer or polar ethylene copolymer described above. If used as Layer A in a backsheet film according to the present invention, as discussed below, the silane grafted polyolefin layer thickness would generally be less than about 200 micron (µm), and more preferably less than 100 µm and not sufficient to serve as a typical encapsulation layer that is commonly a film about 450 µm thick. It will, however, in layer A of the present films provide good sealing with such materials used in encapsulation films.

### Layer A Crystalline Olefin Block Composite

In another preferred embodiment of the present invention and depending upon the nature of the encapsulant film layer, a suitable sealing layer can be provided by a *crystalline* block copolymer composite as described above. In a backsheet according to the present invention, depending upon the specific selection of this type of *crystalline* block copolymer composite as the B layer, the B layer can serve as both Layers B and A. In a preferred embodiment, there is provided a novel film comprising Layers B and C. In this embodiment, it may also be desirable to incorporate a minor amount (e.g., less than 25%) of a polar ethylene copolymer in such crystalline block copolymer composite.

### Blends

Blends comprising these polyolefin resins with others as described above can also be used in Layer A of films according to the invention. In other words, Layer A polyolefin polymers can be blended or diluted with one or more other polymers to the extent that the polyolefin is (i) miscible with the other polymer, (ii) the other polymer has little, if any, deleterious impact on the desirable properties of the polyolefin polymer, e.g., toughness and modulus, and (iii) the polyolefin polymer of this invention constitutes at least about55, preferably at least about 70, preferably at least about 75 and more preferably at least about 80, weight percent of the blend.

Layer A is a layer in a backsheet film.

In an embodiment, there is provided a PV module comprising a backsheet film comprising a Layer A. In an embodiment, there is provided a PV module comprising a film having a Layer A, the film selected from a backsheet film, a front encapsulant film, a back encapsulant film, and combinations thereof.

In an embodiment, the encapsulant films of this invention can be made of the same composition as Layer A of a backsheet of this invention.

The encapsulant films of this invention are used on the front side as well as the backside of the PV module.

### Crosslinking in Layers A or B

Although crosslinking is not preferred, due to the low density and modulus of the polyolefin resins used in the practice of this invention, these polymers can be cured or crosslinked at the time of lamination or after, usually shortly after, assembly of the layers into the multilayered article, e.g., PV module. Crosslinking can be initiated and performed by any one of a number of different and known methods, e.g., by the use of thermally activated initiators, e.g., peroxides and azo compounds; photoinitiators, e.g., benzophenone; radiation techniques including Electron-beam and x-ray; vinyl silane, e.g., vinyl tri-ethoxy or vinyl tri-methoxy silane; and moisture cure.

### Additives in Layers A, B, or C

The individual layers of the multilayered structure can further comprise one or more additives. Exemplary stabilizer additives include UV-stabilizers, UV-absorbers, and antioxidants. These stabilizer additives are useful in, e.g., reducing the oxidative degradation and improving the weatherability of the product. Suitable stabilizers include hindered amines and benzoates such as Cynergy A400, A430,and R350, Cyasorb UV-3529, Cyasorb UV-3346, Cyasorb UV-3583, Hostavin N30, Univil 4050, Univin 5050, Chimassorb UV-119, Chimassorb 944 LD and Tinuvin 622 LD; UV absorbers such as Tinuvin 328, Cyasorb UV-531 or Cyasorb UV-1164 and; primary and secondary antioxidants such as Cyanox 2777, Irganox 1010, 1076, B215, B225, , PEPQ, Weston 399, TNPP, Nauguard 412S, Nauguard DLTDP, Irgafos 168 and Doverphos 9228. The amounts of stabilizers needed depend on the type, aging environment and longevity desired and are used in the manner and, as is commonly known in the art, the amounts typically range between greater than about 0.01 and less than about 3% weight percent based on the polymer weight being stabilized.

Other additives that can be used include ignition resistance additives, anti-blocks such as diatomaceous earth, superfloss, silicates, talc, mica, wolastonite, and epoxy coated talcs; slip additives such as erucamde and stearamide, polymer process aids such as Dyneon fluropolymer elastomers like Dynamar FX5930, pigments and fillers such as TiO2 R960, R350, R105, R108, R104, carbon blacks such as used in Dow DNFA-0037 masterbatch or provided by Cabot. These and other potential additives are used in the manner and amount as is commonly known in the art.

The encapsulant layer can be made as an individual layer for use in the PV or ED module.

### Multilayer Film Structures and ED Modules

In describing the use of the polymer components above to make laminate or layered structures, there are a number of terms that are regularly used and defined as follows.

"Layer" means a single thickness, coating or stratum continuously or discontinuously spread out or covering a surface.

"Multi-layer" means at least two layers.

"Facial surface", "planar surface" and like terms as related to films or layers mean the surfaces of the layers that are in contact with the opposite and adjacent surfaces of the adjoining layers. Facial surfaces are in distinction to edge surfaces. A rectangular film or layer comprises two facial surfaces and four edge surfaces. A circular layer comprises two facial surfaces and one continuous edge surface.

"In adhering contact" and like terms mean that one facial surface of one layer and one facial surface of another layer are in touching and binding contact to one another such that one layer cannot be removed for the other layer without damage to the in-contact facial surfaces of both layers.

"Sealing relationship" and like terms mean that two or more components, e.g., two polymer layers, or a polymer layer and an electronic device, or a polymer layer and a glass cover sheet, etc., join with one another in such a manner, e.g., co-extrusion, lamination, coating, etc., that the interface formed by their joining is separated from their immediate external environment.

The polymeric materials as discussed above can be used in this invention to construct multilayer structure film or sheet, which is used in turn to construct and electronic device (ED) modules in the same manner and using the same amounts as is known in the art, e.g., such as those taught in USP 6,586,271, US 2001/0045229 A1, WO 99/05206 and WO 99/04971. These materials can be used to construct "skins" for the electronic device, i.e., multilayered structures for application to one or both face surfaces of the device, particularly the back surface of such devices, i.e.,"backsheets". Preferably these multilayered structures, e.g., backsheets, are co-extruded, i.e., all layers of the multilayered structures are extruded at the same time, such that as the multilayered structure is formed.

Depending upon their intended use, the multilayer film or sheet structures according to the present invention can be designed to meet certain performance requirements such as in the areas of physical performance properties including toughness, transparency, tensile strength, interlayer adhesion, and heat resistance; electrical properties such as insulation, dielectric breakdown, partial discharge and resistance; reflectance; and appearance.

### Layer C - Comprising High Melting Point Polyolefin Resins

In general, Layer C in the multilayer backsheet structures according to the present invention is prepared from the "Layer C High Melting Point Polyolefin Resins" as discussed above. In one preferred embodiment, it is preferably a highly crystalline homopolymer polypropylene resin. Depending upon the specific performance requirements for the film and/or a module structure in which it is intended for use, the thickness of Layer C is typically in the range of from about 100 µm to about 375µm. As for minimum thickness, Layer C is preferably at least about 125 µm, more preferably at least about 150 µm, more preferably at least about 160 µm and most preferably at least about 170 µm thick. As for maximum thickness, the thickness of Layer C can be up to and including about 350 µm, preferably about 300 µm, more preferably about 275 µm and most preferably about 250 µm.

### Layer B -Comprising Polyolefin Block Copolymer Composite Resin

Layer B in the multilayer backsheet film structures according to the present invention is prepared from the "Layer B Polyolefin Block Composite Resins" as discussed above, comprising a crystalline block copolymer composite resin. Depending upon the specific performance requirements for the film and/or a module structure in which it is intended for use, the thickness of Layer B is typically in the range of from about 1 µm to about 200 µm. As for minimum thickness, Layer B is only as thick as needed to tie the adjacent Layers A and C together and can preferably be at least about 2 µm, preferably at least about 3 µm, preferably at least about 4 µm, more preferably at least about 10 µm, more preferably at least about 15 µm, more preferably at least about 20 µm and most preferably at least about 25 µm thick. As for maximum thickness, the thickness and cost of Layer B are desirably minimized but are preferably up to and including about 150 µm, preferably about 100 µm, more preferably about 75 µm and most preferably up to and including about 50 µm thick.

There is provided an electronic device wherein the film is a backsheet comprising Layer C and wherein Layer B performs as both tie layer and seal Layer A for lamination to the encapsulant film, Layer B would typically range in thickness from about 20 to about 250 micrometers ("µm"). In such films Layer B is only as thick as needed to adhere to Layer C and seal the backsheet to the adjacent encapsulation layer in the electronic device, preferably at least about 30 µm, preferably at least about 40 µm, and most preferably at least about 50 µm thick. As for maximum thickness, the thickness and cost of Layer B are desirably minimized but can preferably be up to and including about 225 µm, preferably about 200 µm, more preferably about 175 µm, and most preferably up to and including about 150 µm. With Layer B as a surface seal layer it is preferably a blend comprising the CBC and one or more other components such as polymer process aids, colorants, and slip or anti-block additives.

### Layer A - Seal Layer

The top or seal Layer A adheres the films according to the present invention to an encapsulating film. Depending upon the specific performance requirements for the film and/or a module structure in which it is intended for use, the thickness of Layer A is typically in the range of from about 15µm to about 500 µm. As for minimum thickness, Layer A is only as thick as needed to adhere the backsheet to the encapsulation film layer and should be at least about 17 µm, preferably at least about 20 µm , more preferably at least about 23 µm and most preferably at least about 25 µmµ thick. As for maximum thickness, the thickness and cost of Layer A are desirably minimized but can be up to and including about 450 µm, preferably about 400 µm, more preferably about 350 µm, and most preferably up to and including about 300 µm.

### Film Structure and Thickness

The composition of the layers can be selected and optimized along the lines discussed herein depending upon the intended film structure and usage of the film structure. For example, for use in electronic device laminate structures multilayer films according the present invention, the films can be employed as a 2 layer backsheet or a 3 layer backsheet (comprising both a tie layer and a top seal layer). The films are suitable to be employed as, among other things, backsheet layers for direct use in laminate electronic device structures, such as, for example PV modules.

In all cases, the top facial surface of the multilayered film structure exhibits good adhesion for the facial surfaces of the encapsulation layer material that encapsulates the device.

Depending somewhat upon the specific structure and process for utilizing the film or sheet that structures according to the present invention, such film structures can be prepared by any of a large number of known film production processes including extrusion or co-extrusion methods such as blown-film, modified blown-film, calendaring and casting, as well as sheet extrusion using a roll stack. There are many known techniques which can be employed for providing multilayer films (up to and including microlayer films), including for example in USP 5,094,788; USP 5,094,793; WO/2010/096608; WO 2008/008875; USP 3,565,985; USP 3,557,265; USP 3,884,606; USP 4,842,791 and USP 6,685,872. Layers A, B and C of the films according to the present invention, are selected to be adhered simultaneously together preferably by co-extrusion or alternatively but less preferably by a lamination process (such as extrusion lamination, thermal lamination, or adhesive lamination) into the films according to the invention. Alternatively but less preferably, a sequential process can be employed to adhere pairs of layers together and to the third and any optional layers.

The overall thickness of the multilayered films and, in particular backsheet structures, prior to attachment to other layers such as encapsulant layers, electronic devices and/or anything else, is typically between about 50 µm and about 825 µm. Preferably to provide sufficient physical properties and performance, the film thickness is at least about 75 µm, and more preferably at least about 125 µm. To maintain light weight and low costs, but retain the requisite electrical properties, the film thickness is preferably 775 µm or less, more preferably 575 µm or less. This includes any optional, additional layers that form and are an integral part of the multilayer structure comprising layers A, B and C.

### PV Module Structures and Terms

In the electronic device (and especially the PV module) embodiments of the present invention, the top layer or coversheet 13 and the top encapsulating layer 12a generally need to have good, typically excellent, transparency, meaning transmission rates in excess of 90, preferably in excess of 95 and even more preferably in excess of 97, percent as measured by UV-vis spectroscopy (measuring absorbance in the wavelength range of about 250-1200 nanometers. An alternative measure of transparency is the internal haze method of ASTM D-1003-00. If transparency is not a requirement for operation of the electronic device, then the polymeric material can contain opaque filler and/or pigment.

The thicknesses of all the electronic device module layers, described further below, both in an absolute context and relative to one another, are not critical to this invention and as such, can vary widely depending upon the overall design and purpose of the module. Typical thicknesses for protective or encapsulate layers 12a and 12b are in the range of about 0.125 to about 2 millimeters (mm), and for the cover sheet in the range of about 0.125 to about 1.25 mm. The thickness of the electronic device can also vary widely.

### Light transmitting Encapsulation Component or Layer

These layers are sometimes referred to in various types of PV module structures as "encapsulation" films or layers or "protective" films or layers or "adhesive" films or layers. So long as sufficiently light transmitting, these layers can employ the same resins and resin compositions as described above in connection with their use as Layer A for backsheet embodiments. Typically, these layers function to encapsulate and protect the interior photovoltaic cell from moisture and other types of physical damage and adhere it to other layers, such as a glass or other top sheet material and/or a back sheet layer.
Optical clarity, good physical and moisture resistance properties, moldability and low cost are among the desirable qualities for such films. Suitable polymer compositions and films include those used and in the same manner and amounts as the light transmitting layers used in the known PV module laminate structures, e.g., such as those taught in USP 6,586,271, US 2001/0045229 A1, WO 99/05206 and WO 99/04971. These materials can be used as the light transmitting "skin" for the PV cell, i.e., applied to any faces or surfaces of the device that are light-reactive.

### Light transmitting Cover Sheet

Light transmitting cover sheet layers, sometimes referred to in various types of PV module structures as "cover", "protective" and/or "top sheet" layers, can be one or more of the known rigid or flexible sheet materials. Alternatively to glass or in addition to glass, other known materials can be employed for one or more of the layers with which the lamination films are employed. Such materials include, for example, materials such as polycarbonate, acrylic polymers, a polyacrylate, a cyclic polyolefin such as ethylene norbornene, metallocene-catalyzed polystyrene, polyethylene terephthalate, polyethylene naphthalate, fluoropolymers such as ETFE (ethylene-tetrafluoroethylene), PVF (polyvinyl fluoride), FEP (fluoroethylene-propylene), ECTFE (ethylene-chlorotrifluoroethylene), PVDF (polyvinylidene fluoride), and many other types of plastic or polymeric materials, including laminates, mixtures or alloys of two or more of these materials. The location of particular layers and need for light transmission and/or other specific physical properties would determine the specific material selections. As needed and possible based upon their composition, the down conversion/light stabilizer formulations discussed above can be employed in the transparent cover sheets. However, the inherent stability of some of these may not require light stabilization according to the present invention.

When used in certain embodiments of the present invention, the "glass" used as a light transmitting cover sheet refers to a hard, brittle, light transmitting solid, such as that used for windows, many bottles, or eyewear, including soda-lime glass, borosilicate glass, sugar glass, isinglass (Muscovy-glass), or aluminum oxynitride. In the technical sense, glass is an inorganic product of fusion which has been cooled to a rigid condition without crystallizing. Many glasses contain silica as their main component and glass former.

Pure silicon dioxide (SiO2) glass (the same chemical compound as quartz, or, in its polycrystalline form, sand) does not absorb UV light and is used for applications that require transparency in this region. Large natural single crystals of quartz are pure silicon dioxide, and upon crushing are used for high quality specialty glasses. Synthetic amorphous silica, an almost 100 % pure form of quartz, is the raw material for the most expensive specialty glasses.

The glass layer of the laminated structure is typically one of, without limitation, window glass, plate glass, silicate glass, sheet glass, float glass, colored glass, specialty glass which may, for example, include ingredients to control solar heating, glass coated with sputtered metals such as silver, glass coated with antimony tin oxide and/or indium tin oxide, E-glass, and Solexia™ glass (available from PPG Industries of Pittsburgh, PA).

### Laminated PV Module Structures

The methods of making PV modules known in the art can readily be adapted to use the multilayer backsheet film structures. For example, the multilayer backsheet film structures can be used in the PV modules and methods of making PV modules such as those taught in USP 6,586,271, US 2001/0045229 A1, WO 99/05206 and WO 99/04971.

In general, in the lamination process to construct a laminated PV module, at least the following layers are brought into facial contact:
A. A light-receiving top sheet layer (e.g., a glass layer) having an "exterior" light-receiving facial surface and an "interior" facial surface;
B. A front light transmitting thermoplastic polymer film having at least one layer of light transmitting thermoplastic polymers comprising the down conversion/light stabilizer formulations, having one facial surface directed toward the glass and one directed toward the light-reactive surface of the PV cell and encapsulating the cell surface, provided that this layer can be optional in some module structures where the PV cell material may be directly deposited on the light receiving layer (e.g., glass);
C. A PV cell;
D. A second encapsulating film layer; and
E. A back layer comprising glass or other back layer substrate.

An alternative method to construct the module would be to use a combined multilayer back layer (back encapsulant composite) in place of D and E.

With the layers or layer sub-assemblies assembled in desired locations the assembly process typically requires a lamination step with heating and compressing at conditions sufficient to create the needed adhesion between the layers and, if needed in some layers or materials, initiation of their crosslinking. If desired, the layers may be placed into a vacuum laminator for 10 to 20 minutes at lamination temperatures in order to achieve layer-to-layer adhesion and, if needed, crosslinking of the polymeric material of the encapsulation element. In general, at the lower end, the lamination temperatures need to be at least about 130°C, preferably at least about 140°C and, at the upper end, less than or equal to about 170°C, preferably less than or equal to about 160°C.

### Organo-Clay

As used herein, an organoclay (also known as organophilic clay) is generally an organic modified layered silicate. Examples of such layered silicates include natural and/or synthetic layered silicates such as montmorillonite, bentonite, kaolinite, kaolin, mica, hectorite, sauconite, fluorohectorite, saponites, attapulgite, sepiolite, beidellite, ledikite, nontronite, volkonskoite, stevensite, vermiculite, halloysite, talc, pyrophillite, palygorskite, illite, phlogopite, biotite, chlorite, nacrite, dickite, suconite, magadiite, kenyaite, Laponite®, tainiolite, synthetic fluoromica and combination thereof. Organoclays are made by reacting clays with a surfactant, a silane, and/or other surface modifiers. Typically, the surfactants used are quaternary ammonium compounds. Organoclays used in the invention may have an excess of quaternary ammonium compounds. More details of producing organoclays can be found in e.g. USP 5,780,376. Organoclays are also commercially available, such as the CLOISITE® line of natural montmorillonite clays modified with quaternary ammonium salts available from Southern Clay Products, Inc and Somasif TM line of synthetic fluoromica clays modified with quaternary ammonium salts available from CBC Co. Ltd.. In one embodiment the organoclay is added at a level of up to 20 wt % based on the total weight of the polymeric resins in the compound. Typically the amount of organoclay ranges from 0.5 wt % to 10 wt %, more typically from 1 to 5 wt% and even more typically form 1 to 3 wt%, based on the total weight of the resins in the compound. The organoclay can be located in one layer or across multiple layers of the backsheet and encapsulant.

The organoclay can be incorporated into the PV module backsheet and encapsulant compositions by any method that provides adequate distribution and mixing. Typically, the organoclay is melt mixed with the resins in a melt mixer, extruder or similar equipment. Techniques for melt blending of a polymer with additives of all types are known in the art and can typically be used in the practice of this invention. Typically, in a melt blending operation useful in the practice of the present invention, the polymer resin is heated to a temperature sufficient to form a polymer melt and combined with the desired amount of the organoclay in a suitable mixer, such as a single screw or twin-screw extruder, a BANBURY Mixer, a BRABENDER mixer, or a continuous mixer. The composite may be prepared by shearing the polymer and the organoclay in the melt at a temperature equal to or greater than the melting point of the polymer. Mechanical shearing methods are employed such as by extruders, injection molding machines, BANBURY type mixers, or BRABENDER type mixers. The temperature of the melt, residence time of the melt in the extruder and the design of the extruder (single screw, twin screw, number of flights per unit length, channel depth, flight clearance, mixing zone) are several variables which control the amount of shear to be applied. The amount of shear is critical to achieve good clay exfoliation for improved electrical properties. For polyolefins, some compatibilizers such as maleic anhydride (MAH)-grafted polyolefins are added to further improve the clay dispersion and exfoliation.

Alternatively, the polymers may be granulated and dry-mixed with the organoclay and thereafter, the composition heated in a mixer until the polymer resins are melted to form a flowable mixture. This flowable mixture can then be subjected to a shear in a mixer sufficient to form the desired composite. The polymers may also be heated in the mixer to form a flowable mixture prior to the addition of the organoclay. The organoclay and polymer resins are then subjected to a shear sufficient to form the desired composite.

In one embodiment the organoclay is introduced in the form of a masterbatch. In this embodiment, the organoclay is mixed with the base resin and, optionally, one or more additives, to form a concentrate of the desired composition which is then diluted with additional base resin to the desired concentration of organoclay.

The current invention is useful in increasing the volume resistivity or, in other words, reducing leakage current, of polymer films used in the construction of PV modules, particularly polyolefin films used as backsheets and encapsulant for PV modules.

The current invention is further described by the following examples in which all parts and percentages are by weight unless otherwise indicated.

### SPECIFIC EMBODIMENTS

### Materials

CBC1 is a 50/50 ethylene-propylene (EP)/isotactic polypropylene (iPP) diblock copolymer with 90 wt% ethylene-derived units in the EP block and a 7.5 MFR (g/10 min; 230°C/2.16 kg).

CLOISITE Clay 20 A is bis(hydrogenated tallow alkyl)dimethyl, salt with bentonite from Southern Clay Products, Inc.

MAHPECONC1 (AMPLIFY^{tm} TY1053H functional polymer) is a maleic anhydride grafted (MAH-g) high density polyethylene (HDPE) with a density of 0.960 g/cm³ (ASTM D792), a melt index of 2.0 g/10 min (ASTM D1238), a very high MAH graft level, and available from The Dow Chemical Company.

MAHPPCONC1 is a maleic anhydride grafted (MAH-g) polypropylene (PP) with a melt index (MI) of 500 and 0.7 wt% MAH content available from The Dow Chemical Company.

CYANOX^{tm} 1790 antioxidant is 1,3,5-tris(4-tert-butyl-3-hydroxy-2,6-dimethylbenzyl)-1,3,5-triazine-2,4,6-(1H,3H,5H)-trione (CAS No. 040601-76-1) available from Cytec Industries Inc.

The composition of Silane grafted resin 1 is given in weight percent having, 1.7% grafted trimethoxy silane to a polyolefin elastomer with a density of 0.85 and MI of 5.

### Synthesis of Crystalline Block Composites

Catalyst-1 ([[rel-2',2"'-[(1R,2R)-1,2-cylcohexanediylbis(methyleneoxy-κO)] bis[3-(9H-carbazol-9-yl)-5-methyl[1,1'-biphenyl]-2-olato- κ O]](2-)]dimethyl-hafnium) and cocatalyst-1, a mixture of methyldi(C₁₄₋₁₈ alkyl)ammonium salts of tetrakis(pentafluorophenyl)borate, prepared by reaction of a long chain trialkylamine (Armeen™ M2HT, available from Akzo-Nobel, Inc.), HCl and Li[B(C₆F₅)₄], substantially as disclosed in USP 5,919,983, Ex. 2., are purchased from Boulder Scientific and used without further purification.

CSA-1 (diethylzinc or DEZ) and cocatalyst-2 (modified methylalumoxane (MMAO)) were purchased from Akzo Nobel and used without further purification. The solvent for the polymerization reactions is a hydrocarbon mixture (ISOPAR®E) obtainable from ExxonMobil Chemical Company and purified through beds of 13-X molecular sieves prior to use.

The crystalline block composites of the present Examples are designated CBC1. They are prepared using two continuous stirred tank reactors (CSTR) connected in series. The first reactor was approximately 54.6 litres (12 gallons) in volume while the second reactor was approximately 118.2 litres (26 gallons). Each reactor is hydraulically full and set to operate at steady state conditions. Monomers, solvent, hydrogen, catalyst-1, cocatalyst-1, cocatalyst-2 and CSA-1 are fed to the first reactor according to the process conditions outlined in Table 1. The first reactor contents as described in Table 1 flow to a second reactor in series. Additional monomers, solvent, hydrogen, catalyst-1, cocatalyst-1, and optionally, cocatalyst-2, are added to the second reactor. Table 2 shows the analytical characteristics of CBC1. Table 3 shows the ratio of iPP to EP as well as the estimated crystalline block composite index for CBC1.

**Table 1. Reactor process conditions to produce crystalline block composites CBC1**

| Reactor | 1st Reactor | 2nd Reactor |
|---|---|---|
| Reactor Control Temp.(°C) | 141 | 135 |
| Solvent Feed (kg/hr) ((1b/hr)) | 110 (242) | 111 (245) |
| Propylene Feed (kg/hr) ((1b/hr)) | 2.47 (5.44) | 22.12 (48.76) |
| Ethylene Feed (kg/hr) ((1b/hr)) | 21.3 (47.0) | 0.0 (0.0) |
| Hydrogen Feed (SCCM) | 9.5 | 0.0 |
| Reactor Propylene Conc. (g/L) | 3.57 | 2.26 |
| Catalyst Efficiency (gPoly/gM) *1.0E6 | 0.706 | 0.075 |
| Catalyst Flow (kg/hr) ((1b/hr)) | 0.21 (0.47) | 0.81 (1.78) |
| Catalyst Conc. (ppm) | 150 | 500 |
| Cocatalyst-1 Flow (kg/hr) ((1b/hr)) | 0.64 (1.41) | 0.51 (1.12) |
| Cocatalyst-1 Conc. (ppm) | 500 | 8000 |
| Cocat.-2 Flow (kg/hr) ((1b/hr)) | 0.54 (1.18) | 4.53 (9.98) |
| Cocat.-2 Conc. (ppm) | 1993 | 1993 |
| DEZ Flow (kg/hr) ((1b/hr)) | 0.86 (1.89) | 0.00 (0.00) |
| DEZ Conc. (ppm) | 30000 | 0 |
| Production Rate (kg/hr) ((1b/hr)) | 22.5 (49.5) | 25.4 (56.1) |

**Table 2 Crystalline block composite physical properties**

| Sample | MFR (230°C/2.16 kg) | Wt% PP from HTLC Separation | Mw Kg/m ol | Mw /Mn | Total Wt% C₂ | Tm(°C) Peak 1 (Peak 2) | Tc (°C) | Melt Enthalpy (J/g) |
|---|---|---|---|---|---|---|---|---|
| CBC1 | 7.5 | 19.4 | 109 | 2.8 3 | 48.3 | 129 (108) | 91 | 91 |

**Table 3 Crystalline Block Composite Index Estimation**

| Sample | wt% iPP | wt% EP | Wt% C₂ in EP | Crystalline Block Composite Index |
|---|---|---|---|---|
| CBC1 | 50 | 50 | 90 | 0.583 |

### Compounding and Compression Molding

Examples 1-8 are dry blended and fed to a Haake/Leistritz 18 mm twin screw extruder at approximately 2.7 kg/hr (6 pounds per hour). The torque is measured at 6000 meter-grams, and a die pressure of 5.17 MPa (750 psi). The temperature profile of the five zones and the die is 135, 150, 175, 190, 200 and 200 °C, respectively. The melt temperature is 206°C. Before compounding the 20 angstrom (Å) clay, it is vacuum dried overnight at 70°C and so is MAHPECONC1. The formulation for compounding is shown in Table 4. For electrical testing, the compounded materials are compression molded into plaques. About 2.0 grams of the indicated resin is weighed and placed between silicon papers, which are then placed between two metal plates that, when closed together, leave a 0.508 millimeter (0.02 inch) gap between them. The plates are then placed in the platen press at 148.9 °C (300°F) and 11.4 metric tons (25 tons) of pressure for 1 minute, and then placed for 30 seconds on the cold portion of the press at 11.4 metric tons (25 tons) of pressure. The sample is compressed to a film that is is roughly circular, about 101.6 mm (4 inches) in diameter and about 457 µm (18 mils) thick.

### Electrical Testing

The electrical performance of encapsulant films is tested as follows. A Keithley 8009 resistivity test fixture with 6517B Electrometer is used. The test fixture, located in the electrical resistivity test box, is placed in an oven heated to 60°C and the electrometer is zeroed. A 76 mm (3inch) diameter of film is cut and placed in the fixture in the oven for testing. The leakage current (I) is measured after applying 1000V across the film. The data after 10 minutes of voltage (V) application is reported as the leakage current. Resistivity (R) is then calculated taking thickness (t) of the film into consideration using the following relation : R = A^{∗}V/ (I^{∗}t), where R is the volume resistivity in Ohm-cm, A is the area of electrodes in cm², V is the voltage, I is the current in Amps, and t is the thickness of the film in 30 cm. The results are reported in Figure 2 and Table 4.

### Masterbatch 1 Preparation

The composition of the Masterbatch 1 is, in weight percent (wt%) based on the total weight of the masterbatch, 50% CBCl, 20% clay, 30% MAHPECONC1 and 0.03% CYANOX^{tm} 1790 antioxidant. The composition is dry blended and fed to a Haake/Leistritz 18 mm twin screw extruder at approximately 2.7 kg/hr (6 pounds per hour). The temperature profile of the five zones and the die is 135, 150, 175, 190, 200 and 200 °C, respectively. The masterbatch is also vacuum dried overnight at 70°C. The clay masterbatch is dried overnight under vacuum at 60°C prior to use to make Examples 9-11 samples as shown in Table 5. The masterbatch is used to prepare PV module backsheet films for various property measurements and electrical performance.

### Film Composition and Preparation

Table 5 reports the compositions and certain properties of PV module backsheet films. Table 6 reports the conditions and equipment used to prepare the PV module backsheet films.

**Table 4**

| Film Compositions and Selected Properties | | | | | | |
|---|---|---|---|---|---|---|
| Examples | CBC1 (%) | Clay 20A (%) | MAHPECONC1 (%) | MAHPPCONC1 (%) | Current at 60°C (Amps) | Thickness (µm) ((mils)) |
| Ex 1* | 98 | 2 | | | 2.89E-10 | 437.1 (17.21) |
| Ex 2* | 94 | 2 | 4 | | 2.43E-11 | 437.1 (17.21) |
| Ex 3* | 94 | 2 | | 4 | 2.79E-10 | 434.1 (17.09) |
| Ex 4* | 96 | 2 | 2 | | 3.48E-11 | 433.8 (17.08) |
| Ex 5* | 96 | 4 | | | 4.20E-10 | 433.6 (17.07) |
| Ex 6* | 88 | 4 | 8 | | 2.27E-11 | 432.1 (17.01) |
| Ex 7* | 88 | 4 | | 8 | 2.21E-10 | 441.2 (17.37) |
| Ex 8* | 92 | 4 | 4 | | 3.47E-11 | 434.8 (17.12) |
| Comp 1 | 100 | | | | 9.61E-09 | 435.9 (17.16) |

| | | | | | | |
|---|---|---|---|---|---|---|
| Resistivity was measured at typical PV module operating temperature of 60C. *Example not within scope of currently claimed invention. | | | | | | |

**Table 5**

| Film Preparation. Description and Selected Properties | | | | | | | | | |
|---|---|---|---|---|---|---|---|---|---|
| Sample ID # | Example 9* | | | Example 10* | | | Example 11 | | |
| Extruder | A | C | B | A | C | B | A | C | B |
| Sheet thickness, µm | 457 | | | 457 | | | 457 | | |
| Layer thickness, µm | 151 | 151 | 155 | 151 | 151 | 155 | 151 | 151 | 155 |
| Layer vol % | 33 | 33 | 34 | 33 | 33 | 34 | 33 | 33 | 34 |
| Materials, wt% | 100 | 100 | 100 | 100 | 100 | 100 | 100 | 100 | 100 |
| CBC1 | | | | | 100 | | | 90 | |
| Masterbatch 1 | | | | | | | | 10 | |
| silane grafted resin 1 | 100 | 100 | 100 | 100 | | 100 | 100 | | 100 |

| Conditions | | | | | | | | | |
|---|---|---|---|---|---|---|---|---|---|
| Extruder | A | C | B | A | C | B | A | C | B |
| RPM | 80 | 80 | 80 | 80 | 80 | 80 | 80 | 80 | 80 |
| Feed zone, °C | 182 | 182 | 182 | 182 | 182 | 182 | 182 | 182 | 182 |
| Zone 2 | 191 | 191 | 191 | 191 | 191 | 191 | 191 | 191 | 191 |
| Zone 3 | 199 | 199 | 199 | 199 | 199 | 199 | 199 | 199 | 199 |
| transfer line, screen, adapters, °C (°F) | 92.8 (199) | 92.8 (199) | 92.8 (199) | 92.8 (199) | 92.8 (199) | 92.8 (199) | 92.8 (199) | 92.8 (199) | 92.8 (199) |
| feedblock, °C (°F) | | | 92.8 (199) | | | 92.8 (199) | | | 92.8 (199) |
| die, °C (°F) | | | 92.8 (199) | | | 92.8 (199) | | | 92.8 (199) |
| Cast roll, °C (°F) | | | 21 | | | 21 | | | 21 |

| | | | | | | | | | |
|---|---|---|---|---|---|---|---|---|---|
| *Example not within scope of currently claimed invention. | | | | | | | | | |

### Module Design, Damp Heat Testing and Power Measurement

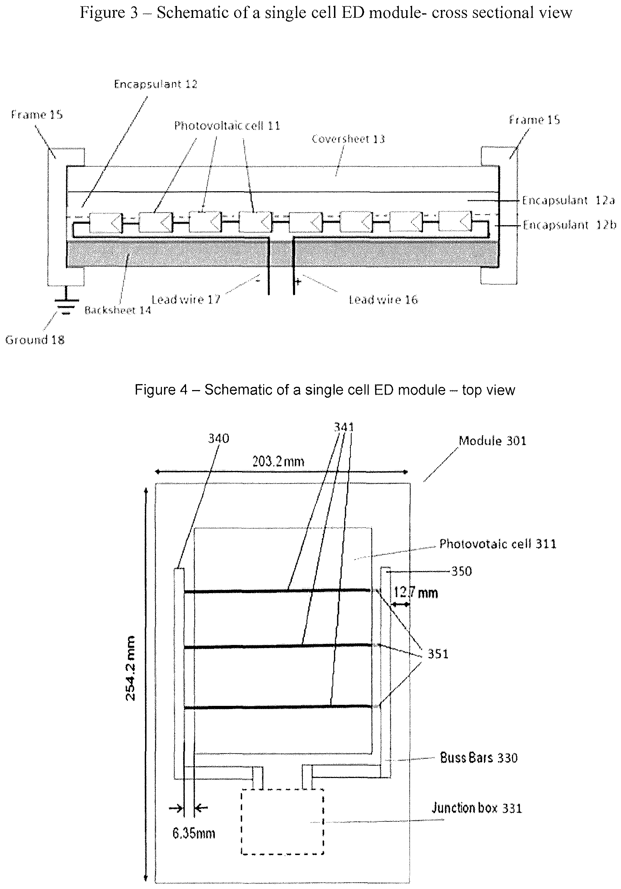

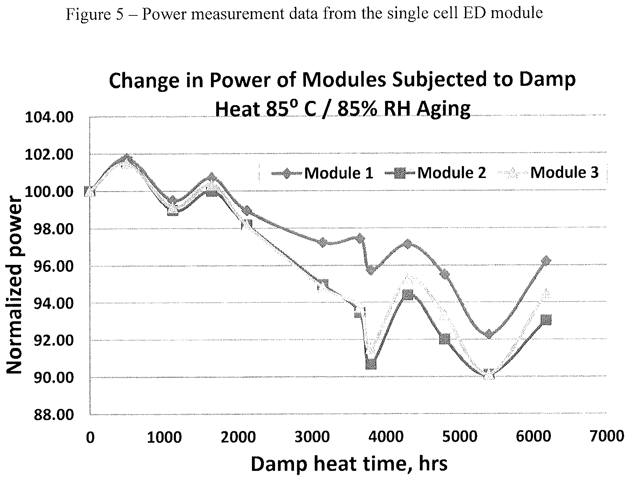

For this test, single cell test PV modules are made having the general structure as shown in Figures 3 and 4. As shown from a top view in Figure 4, a single cell module is prepared using a mono-crystalline silicon solar cell 311. Buss bars 340 and 350 are soldered onto the ribbon leads coming off the top (ribbon lead 341) and bottom (ribbon lead 342) of the cell and terminate in a junction box 331 which can be used for testing cell performance. As the laminate, structure of the module in cross section is shown in Figure 3, the cell is laminated with a solar glass coversheet 213, adding a "top" layer (212a) of encapsulant film, placing the soldered cell 211 face down a uniform distance from the edges on three sides, placing another layer of encapsulant 212b and a protective backsheet 214 and laminating at 150°C to produce the single cell module. The leads 216 and 217 are projected out of the backsheet by making necessary slits in the backsheet and back encapsulant. A junction box 231 is 20 attached to the leads and the box is adhered onto the backsheet. The structure of three test modules are reported in Table 6 and the results of heat aging these modules are reported in Figure 5.

The modules are "flashed" to measure power using a SPIRE sun simulator. Then the modules are placed in an oven at 85°C and 85% relative humidity (RH) for various periods of time and power is measured within 2 hours of taking out from the oven and put back in the oven to continue the testing. The normalized power is plotted in Figure 5 (normalization using initial power at time zero) vs. time of ageing in the oven. The figure shows minimal drop in power after ∼3000 hrs of damp heat ageing at 85⁰C and 85% RH. It shows the module (Module 1) with example 9 control film with the lowest power drop followed by the other two example modules. After 6000hr, the Module 3 with example 11 film is starting to show better performance than Module 2 which has the higher leakage current film (example 10) used in the module.

**Table 6**

| Construction of Four Test Modules | | | |
|---|---|---|---|
| | Module 1* | Module 2* | Module 3 |
| Glass | solar | solar | solar |
| front encapsulant film | example 9 | example 9 | example 9 |
| cells | 15.2 cm x 15.2 cm (6" x 6") mono crystalline | 15.2 cm x 15.2 cm (6" x 6") mono crystalline | 15.2 cm x 15.2 cm (6" x 6") mono crystalline |
| back encapsulant film | example 9* | example 10* | example 11 |
| backsheet | Protekt HD | Protekt HD | Protekt HD |

| | | | |
|---|---|---|---|
| *comparative | | | |

## Claims

1. A PV module comprising an organoclay;
wherein the PV module comprises at least the following layers in facial contact:
a light-receiving top sheet layer;
a front encapsulating film;
a PV cell;
a back encapsulating film comprising the organoclay and a crystalline block copolymer composite resin; and
a backsheet, the backsheet comprising a seal layer in facial contact with the back encapsulating film, a tie layer, and a bottom layer, wherein the tie layer comprises a crystalline block copolymer composite resin;
wherein the crystalline block copolymer composite of the back encapsulating film and the tie layer comprises a crystalline ethylene based polymer (CEP), a crystalline alpha-olefin based polymer (CAOP), and a block copolymer having a crystalline ethylene block (CEB) and a crystalline alpha-olefin block (CAOB), wherein the CEB of the block copolymer is the same composition as the CEP in the block composite and the CAOB of the block copolymer is the same composition as the CAOP of the block composite;
wherein the back encapsulating film further includes a maleic anhydride-grafted polyolefin, wherein the maleic anhydride-grafted polyolefin comprises a maleic anhydride-grafted high density polyethylene.

2. The PV module of Claim 1 in which the organoclay comprises from 1 to 5 wt% of the encapsulant.

3. The PV module of Claim 1 in which the organoclay is an organic modified natural and/or synthetic layered silicate.

4. The PV module of Claim 3 in which the organoclay is a natural montmorillonite clay modified with a quaternary ammonium salt.

5. The PV module of Claim 1 in which the backsheet comprises a (i) bottom layer having opposing facial surfaces and comprising a polyolefin resin with a melting point of at least 125°C, (ii) wherein the tie layer has opposing facial surfaces of which one is in direct contact with one of the facial surfaces of the bottom layer, the tie layer further comprising a block composite resin, and (iii) a seal layer having opposing facial surfaces of which one is in direct contact with the facial surface of the tie layer not in contact with the bottom layer, the seal layer comprising a thermoplastic ethylene-based polymer, at least one of the bottom, tie and seal layers comprising the organoclay.

6. The PV module of Claim 1, wherein the organoclay comprises from 1 to 3 wt% of the back encapsulating film.

## Patentansprüche

1. Ein PV-Modul, beinhaltend einen Organo-Ton;
wobei das PV-Modul mindestens die folgenden Schichten in flächenmäßigem Kontakt beinhaltet:
eine lichtaufnehmende Decklagenschicht;
eine vorderseitige einkapselnde Folie;
eine PV-Zelle;
eine rückseitige einkapselnde Folie, beinhaltend den Organo-Ton und ein kristallines Blockcopolymer-Kompositharz; und
eine Rückseitenlage, wobei die Rückseitenlage eine Siegelschicht in flächenmäßigem Kontakt mit der rückseitigen einkapselnden Folie, eine Verbindungsschicht und eine Bodenschicht beinhaltet, wobei die Verbindungsschicht ein kristallines Blockcopolymer-Kompositharz beinhaltet;
wobei das kristalline Blockcopolymer-Komposit der rückseitigen einkapselnden Folie und die Verbindungsschicht ein kristallines ethylenbasiertes Polymer (CEP), ein kristallines alpha-Olefin-basiertes Polymer (CAOP) und ein Blockcopolymer mit einem kristallinen Ethylenblock (CEB) und einem kristallinen alpha-Olefinblock (CAOB) beinhaltet, wobei der CEB des Blockcopolymers die gleiche Zusammensetzung ist wie das CEP in dem Blockkomposit und der CAOB des Blockcopolymers die gleiche Zusammensetzung ist wie das CAOP des Blockkomposits;
wobei die rückseitige einkapselnde Folie ferner ein maleinsäureanhydridgepfropftes Polyolefin umfasst, wobei das maleinsäureanhydridgepfropfte Polyolefin ein maleinsäureanhydridgepfropftes Polyethylen hoher Dichte beinhaltet.

2. PV-Modul gemäß Anspruch 1, in dem der Organo-Ton zu 1 bis 5 Gew.-% das Einkapselungsmittel beinhaltet.

3. PV-Modul gemäß Anspruch 1, in dem der Organo-Ton ein organisches modifiziertes natürliches und/oder synthetisches Schichtsilikat ist.

4. PV-Modul gemäß Anspruch 3, in dem der Organo-Ton ein natürlicher, mit einem quartären Ammoniumsalz modifizierter Montmorillonit-Ton ist.

5. PV-Modul gemäß Anspruch 1, in dem die Rückseitenlage eine (i) Bodenschicht beinhaltet, die gegenüberliegende flächenmäßige Oberflächen aufweist und ein Polyolefinharz mit einem Schmelzpunkt von mindestens 125 °C beinhaltet, (ii) wobei die Verbindungsschicht gegenüberliegende flächenmäßige Oberflächen aufweist, von denen eine in direktem Kontakt mit einer der flächenmäßigen Oberflächen der Bodenschicht steht, wobei die Verbindungsschicht ferner ein Blockkompositharz beinhaltet, und (iii) eine Siegelschicht mit gegenüberliegenden flächenmäßigen Oberflächen, von denen eine in direktem Kontakt mit der flächenmäßigen Oberfläche der Verbindungsschicht steht, die nicht in Kontakt mit der Bodenschicht steht, wobei die Siegelschicht ein thermoplastisches ethylenbasiertes Polymer beinhaltet, wobei mindestens eine der Boden-, Verbindungs- und Siegelschicht den Organo-Ton beinhaltet.

6. PV-Modul gemäß Anspruch 1, wobei der Organo-Ton zu 1 bis 3 Gew.-% die rückseitige einkapselnde Folie beinhaltet.

## Revendications

1. Un module PV comprenant une argile organique ;
où le module PV comprend au moins les couches suivantes en contact facial :
une couche formant feuille supérieure de réception de lumière ;
un film d'encapsulation avant ;
une cellule PV ;
un film d'encapsulation arrière comprenant l'argile organique et une résine composite de copolymère à blocs cristallins ; et
une feuille arrière, la feuille arrière comprenant une couche de scellement en contact facial avec le film d'encapsulation arrière, une couche de liaison, et une couche inférieure, où la couche de liaison comprend une résine composite de copolymère à blocs cristallins ;
où le composite de copolymère à blocs cristallins du film d'encapsulation arrière et de la couche de liaison comprend un polymère à base d'éthylène cristallin (CEP) un polymère à base d'alpha-oléfine cristallin (CAOP), et un copolymère à blocs ayant un bloc d'éthylène cristallin (CEB) et un bloc d'alpha-oléfine cristallin (CAOB), où le CEB du copolymère à blocs est de même composition que le CEP dans le composite à blocs et le CAOB du copolymère à blocs est de même composition que le CAOP du composite à blocs ;
où le film d'encapsulation arrière inclut en outre une polyoléfine greffée avec de l'anhydride maléique, où la polyoléfine greffée avec de l'anhydride maléique comprend un polyéthylène haute densité greffé avec de l'anhydride maléique.

2. Le module PV de la revendication 1 dans lequel l'argile organique constitue de 1 à 5 % en poids de l'encapsulant.

3. Le module PV de la revendication 1 dans lequel l'argile organique est un silicate en couches naturel et/ou synthétique modifié par voie organique.

4. Le module PV de la revendication 3 dans lequel l'argile organique est une argile montmorillonite naturelle modifiée avec un sel d'ammonium quaternaire.

5. Le module PV de la revendication 1 dans lequel la feuille arrière comprend une (i) couche inférieure ayant des surfaces faciales opposées et comprenant une résine polyoléfine avec un point de fusion d'au moins 125 °C, (ii) où la couche de liaison a des surfaces faciales opposées parmi lesquelles une surface est en contact direct avec une des surfaces faciales de la couche inférieure, la couche de liaison comprenant en outre une résine composite à blocs, et (iii) une couche de scellement ayant des surfaces faciales opposées parmi lesquelles une surface est en contact direct avec la surface faciale de la couche de liaison qui n'est pas en contact avec la couche inférieure, la couche de scellement comprenant un polymère à base d'éthylène thermoplastique, au moins une des couches parmi les couches inférieure, de liaison et de scellement comprenant l'argile organique.

6. Le module PV de la revendication 1, où l'argile organique constitue de 1 à 3 % en poids du film d'encapsulation arrière.
